# EUROPÄISCHE PATENTSCHRIFT

(11) **EP 0 590 243 B1**
(45) Veröffentlichungstag und Bekanntmachung des Hinweises auf die Patenterteilung: **06.09.1995**
(21) Anmeldenummer: 93110075.4
(22) Anmeldetag: 24.06.1993
(51) Int. Cl.: C23C 14/56, F16H 25/16, H01L 21/00

(54) **Vorrichtung zum Ein- und Ausschleusen scheibenförmiger Substrate**
Apparatus for loading and unloading disc-shaped substates
Dispositif de chargement et de déchargement de substrats discoides

(30) Priorität: 01.10.1992 DE 4232959
(43) Veröffentlichungstag der Anmeldung: 06.04.1994
(73) Patentinhaber: LEYBOLD AKTIENGESELLSCHAFT, D-63450 Hanau (DE)
(72) Erfinder: Kempf, Stefan, D-8755 Alzenau (DE)

(56) Entgegenhaltungen:
- DE-A- 2 834 353
- DE-A- 3 716 498
- DE-A- 3 804 333
- GB-A- 1 575 400

## Beschreibung

Die Erfindung betrifft eine Vorrichtung zum Ein- und Ausschleusen scheibenförmiger Substrate in und aus einer Vakuum-Beschichtungskammer und zum Transport der Substrate innerhalb dieser Kammer mit mindestens einer Station zum Be- und Entladen und mindestens einer Beschichtungsstation, mindestens einem Hubelement und mindestens einem drehbar gelagerten Substratträger sowie einem Antriebsmotor zur Betätigung des Hubelements und des Substratträgers.

In der Vakuum-Verfahrenstechnik, insbesondere in der Dünnschichttechnik ist das Beschichten von Substraten, beispielsweise von Compact-Discs (CD) hinreichend bekannt. Diese scheibenförmigen Substrate werden als Speichermedium für digitale Informationen vielfältig verwendet. In einem Sputterprozeß werden beispielsweise die geprägten Kunststoffscheiben mit einer Aluminiumschicht überzogen. Die hierzu eingesetzten Sputter-Beschichtungsanlagen besitzen in vielen Fällen einen Drehteller für die Beförderung der Substrate.

Von einem Puffer eines Handling-Systems aus transportiert ein Schwenkarm die Substrate in die Vakuumkammer. In der Kammer werden die Substrate auf einen Drehteller aufgelegt und mit diesem durch die einzelnen Stationen in der Vakuum-Kammer hindurch transportiert. Üblicherweise sind in dieser Kammer mindestens zwei Stationen eingerichtet. Diese sind eine Be- und Entladestation sowie eine Beschichtungsstation.

Durch die deutsche Offenlegungsschrift 37 16 498 ist bereits eine Vorrichtung zum Ein- und Ausschleusen eines im wesentlichen flachen Werkstücks in eine evakuierte Beschichtungskammer und zum Zuführen und Rückführen des Werkstücks in und aus dem Bereich der Beschichtungsquelle zum Zwecke der Behandlung der Werkstückoberfläche bekannt geworden.

Weiterhin ist eine Vorrichtung der in Frage stehenden Art bekannt (US-PS 3.874.525), die eine Beschichtungskammer aufweist, in der ein zweiarmiges Greifwerkzeug um eine vertikale Achse drehbar gelagert ist. Dieses zweiarmige Werkzeug weist an seinen einander diametral gegenüberliegenden Enden Gabeln auf, die mit Hilfe eines Zahnstangenantriebs mit Antriebsmotor in vertikaler Ebene gegenläufig zueinander bewegbar sind. In einer weiteren Schrift (DE 39 12 295) ist eine Kathodenzerstäubungsanlage zur Beschichtung von Substraten in einer Vakuumkammer beschrieben, in der ein rotierender Substratträger untergebracht ist, mit mindestens einer Kathodenstation, einer Be- und Entladestation, wobei der Substratträger aus mindestens einer Transportkelle besteht.

Um diese Transportkellen in Rotationsbewegung zu setzen, wird vorgeschlagen, daß für eine oder mehrere Kellen, eine in Bezug auf die Kathodenzerstäubungsanlage zentral angeordnete Antriebsvorrichtung vorgesehen ist, die die Transportkelle um einen bestimmten Winkel schrittweise in der Vakuumkammer weiter transportiert.

Diese bekannten Vorrichtungen haben alle den Nachteil, daß die Einzelbewegungen durch einzelne Antriebselemente ausgeführt werden. So sind beispielsweise für das Heben und Senken des vor der Kammer angeordneten Schwenkarms sowie für das Heben und Senken der Substratteller innerhalb der Kammer einzelne Pneumatikzylinder eingesetzt. Für die Drehbewegung des Schwenkarms und des Drehtellers sind beispielsweise elektromotorische Antriebe vorgesehen.

Zur Koordination der einzelnen Bewegungen sind eine Vielzahl von Einzelsignalen erforderlich, die zum Beispiel über eine systemprogrammierbare Steuerung (SPS) abgefragt und angesteuert werden. Zur Verarbeitung der Einzelsignale ist eine entsprechende Totzeit erforderlich, in der keine Bewegungen der Antriebselemente ausgeführt werden können. Dies wiederum wirkt sich nachteilig auf die Gesamtzeit eines Beschichtungszyklus aus.

Da die in Frage stehenden Anlagen ausschließlich zur Beschichtung von großen Stückzahlen von Substraten eingesetzt und üblicherweise im Dreischichtbetrieb betrieben werden, ist der Einfluß der Zykluszeit von erheblicher wirtschaftlicher Bedeutung.

Aufgabe der vorliegenden Erfindung ist es nun, die Bewegungen der einzelnen Antriebselemente besser miteinander zu koordinieren um so die Zykluszeit deutlich zu verringern und den Ausstoß der Vorrichtung in Substraten pro Zeiteinheit zu erhöhen.

Erfindungsgemäß wird diese Aufgabe gemäß Anspruch 1 dadurch gelöst, daß zwischen Hubelement und Substratträger einerseits und dem Antriebsmotor andererseits ein Getriebe vorhanden ist, das periodisch sowohl eine Hub- als auch eine Drehbewegung erzeugt.

Durch diese Zwangsführung der einzelnen Hubstangen und Substratträger wird vorteilhafterweise die Erfassung und Verarbeitung von Einzelsignalen, über beispielsweise eine SPS, nicht mehr erforderlich. Für eine bekannte Ausführungsform einer in Frage stehenden Vorrichtung waren bislang beispielsweise 3,3 Sekunden für die Gesamtzykluszeit erforderlich. Nach der erfindungsgemäßen Ausführung wurde vorteilhafterweise die Zykluszeit auf 2,5 Sekunden reduziert. Dies ergibt eine Verbesserung der Zykluszeit um ca. 25% und damit eine Steigerung der Produktivität um ca. 32%, gemessen in Substraten pro Stunde.

Weitere Vorteile und Ausführungsformen der Erfindung sind in den Unteransprüchen 2-14 beschrieben.

Die Erfindung ermöglicht die unterschiedlichsten Ausführungsformen, eine davon ist in den anhängenden Zeichnungen näher beschrieben. Dies sind:
- Fig.1: ein Schwenkarm mit zwei Substrathaltern und ein Drehteller mit drei Substratstationen in der Draufsicht und
- Fig.2: einen Schnitt entlang der Linie XX in Fig. 1, im wesentlichen bestehend aus einem Getriebe zur Steuerung des Schwenkarms sowie ein Drehteller mit den Substrattellern und den dazugehörigen Antrieben.

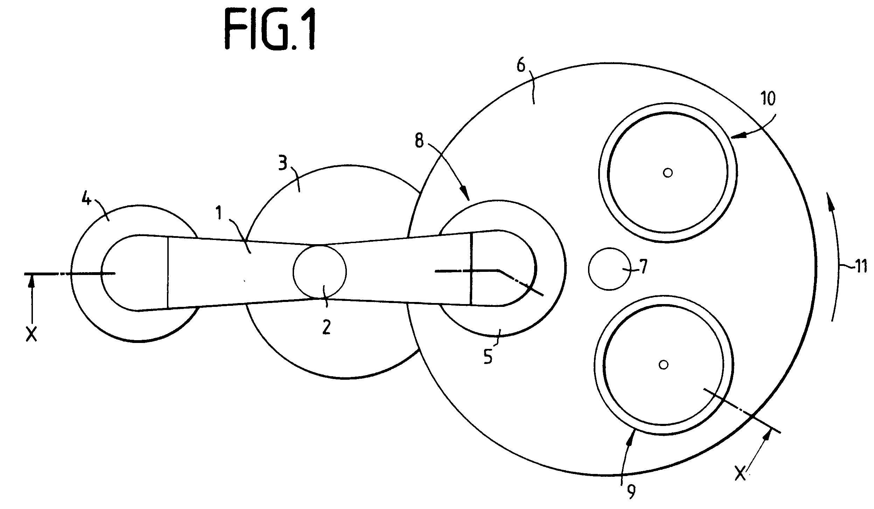

Ein symmetrischer Schwenkarm 1 (Fig. 1) ist durch seine vertikal angeordnete Drehachse 2 mit einem Getriebe 3 verbunden. An den beiden diametral gegenüberliegenden Enden des Schwenkarms 1 sind die tellerförmigen Substrathalter 4, 5 vorgesehen. An den Schwenkarm 1 schließt sich ein kreisrunder Drehteller 6 an, der um seine zentrale Drehachse 7 gelagert ist. Auf diesem Drehteller 6 sind drei Stationen 8, 9, 10 symmetrisch angeordnet. An der Übergabestelle des Substrathalters 5 zum Drehteller 6 befindet sich die Ein- und Ausschleusstation 8. In Drehrichtung 11 des Drehtellers 6 schließen sich dann die Beschichtungsstation 9 und eine Leerstation 10 an.

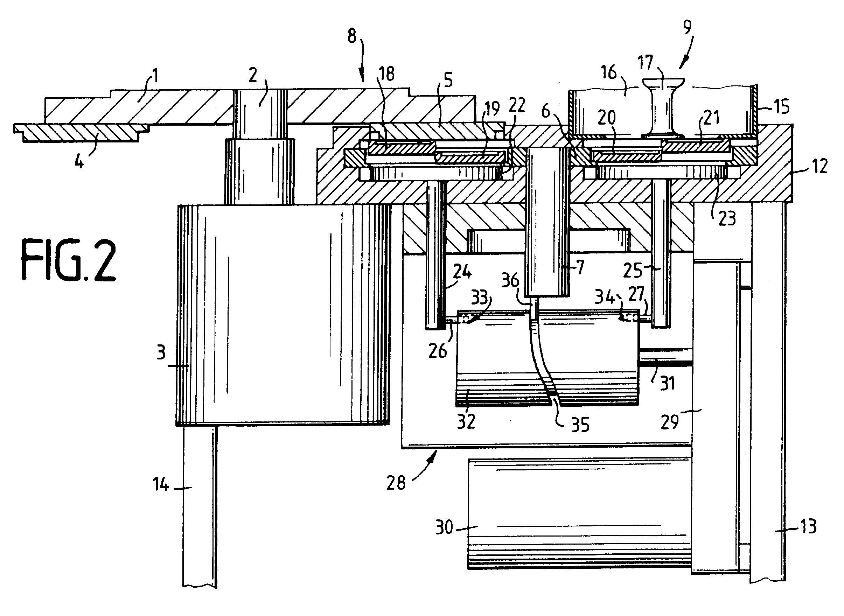

Der Schwenkarm 1 (Fig. 2) ist am oberen Ende der Drehachse 2 befestigt, welche wiederum in das Getriebe 3 eingreift. Die kreisscheibenförmigen Substrathalter 4, 5 sind auf ihrer Unterseite mit einer stufenförmigen Eindrehung versehen. Das Getriebe 3 ist auf das eine äußere Ende einer Bodenplatte 12 angehängt. Die Bodenplatte 12 ist auf Streben 13, 14 aufgelegt.

Die Bodenplatte 12 selbst ist mit diversen Ausnehmungen versehen, in die zum Beispiel der Drehteller 6 eingebaut ist. An der Beschichtungsstation 9 ist durch die Blende 15 die Vakuum-Beschichtungskammer 16 eingegrenzt. Zentrisch in dieser Kammer 16 ist eine Maske 17 vorgesehen, welche den Mittelbereich der Substrate beim Beschichtungsvorgang abdeckt.

In der Ein- und Ausschleusstation 8 ist die eine Hälfte eines Substrathalters in seiner oberen Anschlagposition 18 gezeigt, während die zweite Hälfte denselben Substrathalters in seiner unteren Ruheposition 19 zeigt. Die Positionsänderung wird durch ein Heben und Senken des Substrattellers 22 bewirkt, der mit einer vertikal angeordneten Schubstange 24 verbunden ist.

Synonym zu der Ein- und Ausschleusstation 8 sind in der Beschichtungsstation 9 vergleichbare Einbauteile vorgesehen. Die eine Hälfte eines Substrathalters ist in der unteren Position 20 gezeigt, während die zweite Hälfte desselben Substrathalters in der oberen Anschlagposition 21 dargestellt ist. Auch hier ist wieder ein Substratteller 23 mit einer beweglichen Schubstange 25 verbunden.

Diese beiden Schubstangen 24, 25 ragen in das Gehäuse des Getriebes 28 hinein, welches über eine Halterung 29 mit dem Elektromotor 30 verbunden ist. In dem Getriebe 28 befindet sich im wesentlichen eine horizontal gelagerte Welle 31, an deren Ende sich eine Walze 32 anschließt. Die Walze 32 ist an ihren beiden Stirnseiten mit je einer in sich geschlossenen Nut 33, 34 versehen, welche einen kurvenförmigen, jedoch nicht kreisförmigen Verlauf aufweist. Auf der zylindrischen Mantelfläche der Walze 32 befindet sich eine umlaufende, spindelförmige Nut 35.

An den unteren Enden der beiden Schubstangen 24, 25 sind Stifte 26, 27 in radialer Richtung angebracht, welche in den Nuten 33, 34 geführt sind. Durch den wechselnden radialen Abstand der beiden Nuten 33, 34 zur Drehachse der Walze 32 werden die Kolbenstangen 24, 25 in Achsrichtung gehoben und gesenkt.

Am unteren stirnseitigen Ende der Drehachse 7 des Drehtellers 6 befinden sich Stifte 36 in exzentrischer Position. Diese Stifte 36 greifen in die Nut 35 auf der Mantelfläche der Walze 32 ein und bewirken somit eine periodische Rotation der Drehachse 7 und des Drehtellers 6 um den Teilungswinkel.

### Bezugszeichenliste

- 1: Schwenkarm
- 2: Drehachse
- 3: Getriebe
- 4: Substrathalter
- 5: Substrathalter
- 6: Drehteller
- 7: Drehachse
- 8: Ein-/Ausschleusstation
- 9: Beschichtungsstation
- 10: Leerstation
- 11: Drehrichtung
- 12: Bodenplatte
- 13: Strebe
- 14: Strebe
- 15: Blende
- 16: Vakuum-Beschichtungskammer
- 17: Maske
- 18: Substrathalter, oben
- 19: Substrathalter, unten
- 20: Substrathalter, unten
- 21: Substrathalter, oben
- 22: Substratteller
- 23: Substratteller
- 24: Schubstange
- 25: Schubstange
- 26: Stift
- 27: Stift
- 28: Getriebe
- 29: Halterung
- 30: Elektromotor
- 31: Welle
- 32: Walze
- 33: Nut
- 34: Nut
- 35: Nut
- 36: Stift

## Patentansprüche

1. Vorrichtung zum Ein- und Ausschleusen scheibenförmiger Substrate in und aus einer Vakuum-Beschichtungskammer und zum Transport der Substrate innerhalb dieser Kammer mit mindestens einer Station zum Be- und Entladen und mindestens einer Beschichtungsstation (9),mindestens einem Hubelement und mindestens einem drehbar gelagerten Substratträger sowie einem Antriebsmotor zur Betätigung des Hubelements und des Substratträgers, **dadurch gekennzeichnet,** daß zwischen Hubelement und Substratträger einerseits und dem Antriebsmotor andererseits ein Getriebe (3, 28) vorhanden ist, das während der Benützung periodisch sowohl eine Hub- als auch eine Drehbewegung erzeugt.

2. Vorrichtung nach Anspruch 1, **dadurch gekennzeichnet,** daß der Antriebsmotor ein Elektromotor (30) ist.

3. Vorrichtung nach Anspruch 1, **dadurch gekennzeichnet,** daß das Getriebe (3, 28) ein mechanisches Getriebe ist.

4. Vorrichtung nach Anspruch 1, **dadurch gekennzeichnet,** daß das Hubelement als Schubstange (24, 25) ausgeführt ist.

5. Vorrichtung nach Anspruch 1, **dadurch gekennzeichnet,** daß der Substratträger als Schwenkarm (1) oder als Drehteller (6) ausgebildet ist.

6. Vorrichtung nach Anspruch 1, **dadurch gekennzeichnet,** daß das Getriebe (3, 28) als Kurvengetriebe mit einer zylindrischen Walze (32) ausgeführt ist.

7. Vorrichtung nach Anspruch 6, **dadurch gekennzeichnet,** daß in der Stirnseite der Walze (32) eine in sich geschlossene Nut (33, 34) und an einem Ende der Schubstange (24, 25) Führungsmittel, vorzugsweise Stifte (26, 27) vorhanden sind, die in dieser Nut (33, 34) geführt sind.

8. Vorrichtung nach Anspruch 6**, dadurch gekennzeichnet,** daß auf der zylindrischen Mantelfläche der Walze (32) eine umlaufende, vorzugsweise spindelförmige Nut (35) und an der Drehachse (7) des Drehtellers (6) Führungsmittel, vorzugsweise Stifte (36) vorhanden sind, die in dieser Nut (35) geführt sind.

9. Vorrichtung nach Anspruch 1, **dadurch gekennzeichnet,** daß ein um eine ortsfeste Drehachse (7) rotierbarer Drehteller (6) innerhalb der Kammer angeordnet ist.

10. Vorrichtung nach Anspruch 9, **dadurch gekennzeichnet,** daß der Drehteller (6) mit mindestens zwei Ausnehmungen versehen ist, in denen Substratteller (22, 23) zum Heben und Senken der Substrate gehalten und geführt sind.

11. Vorrichtung nach Anspruch 10, **dadurch gekennzeichnet,** daß die Substratteller (22, 23) mit je einer Schubstange (24, 25) verbunden sind.

12. Vorrichtung nach Anspruch 11, **dadurch gekennzeichnet,** daß die Schubstangen (24, 25) und die Drehachse (7) mit einem Getriebe (28) verbunden sind, welches unterhalb der Kammer (16) angeordnet ist.

13. Vorrichtung nach Anspruch 5, **dadurch gekennzeichnet,** daß ein Schwenkarm (1) außerhalb der Kammer (16) angeordnet und mit einem Getriebe (3) verbunden ist.

14. Vorrichtung nach Anspruch 13**, dadurch gekennzeichnet,** daß der Schwenkarm (1) mit dem Getriebe (3) so zusammenwirkt, daß er eine Hub- und Drehbewegung ausführt.

## Claims

1. Apparatus for loading and unloading disc-shaped substrates into and from a vacuum coating chamber and for conveying the substrates inside said chamber, having at least one bay for loading and unloading and at least one coating bay (9), at least one lifting element, at least one rotatably mounted substrate support, and a drive motor for actuating the lifting element and the substrate support, characterised in that a transmission (3, 28) is provided between the lifting element and the substrate support on the one hand and the drive motor on the other hand, said transmission periodically generating both a lifting and a rotary movement.

2. Apparatus according to claim 1, characterised in that the drive motor is an electric motor (30).

3. Apparatus according to claim 1, characterised in that the transmission (3, 28) is a mechanical transmission.

4. Apparatus according to claim 1, characterised in that the lifting element is formed as a connecting rod (24, 25).

5. Apparatus according to claim 1, characterised in that the substrate support is formed as a swivel arm (1) or as a turntable (6).

6. Apparatus according to claim 1, characterised in that the transmission (3, 28) is formed as a cam mechanism with a cylindrical roller (32).

7. Apparatus according claim 6, characterised in that a continuous groove (33, 34) is provided on the end face of the roller (32) and guide means, preferably pins (26, 27), which are guided in said groove (33, 34), are provided at one end of the connecting rod (24, 25).

8. Apparatus according to claim 6, characterised in that a continuous, preferably spindle-shaped groove (35) is provided on the cylindrical surface of the roller (32) and guide means, preferably pins (36), which are guided in said groove (35), are provided on the rotary shaft (7) of the turntable (6).

9. Apparatus according to claim 1, characterised in that a turntable (6) rotatable about a fixed rotary shaft (7) is disposed inside the chamber.

10. Apparatus according to claim 9, characterised in that the turntable (6) is provided with at least two recesses in which substrate plates (22, 23) are held and guided for raising and lowering the substrates.

11. Apparatus according to claim 10, characterised in that the substrate plates (22, 23) are each connected to a respective connecting rod (24, 25).

12. Apparatus according to claim 11, characterised in that the connecting rods (24, 25) and the rotary shaft (7) are connected to a transmission (28) disposed below the chamber (16).

13. Apparatus according to claim 5, characterised in that a swivel arm (1) is disposed outside the chamber (16) and is connected to a transmission (3).

14. Apparatus according to claim 13, characterised in that the swivel arm (1) cooperates with the transmission (3) so as to perform a lifting and rotary movement.

## Revendications

1. Dispositif pour l'entrée et la sortie de substrats en forme de disque dans et hors d'une chambre de revêtement sous vide, et pour le transport des substrats à l'intérieur de cette chambre, comportant au moins une station pour le chargement/déchargement, et au moins une station de revêtement (9), au moins un élément de levage et au moins un porte-substrats monté en rotation, ainsi qu'un moteur d'entraînement pour l'actionnement de l'élément de levage et du porte-substrats, caractérisé en ce qu'il est prévu entre l'élément de levage et le porte-substrats d'une part, et le moteur d'entraînement d'autre part une transmission (3, 28) qui produit pendant l'utilisation périodiquement aussi bien un mouvement de levage qu'un mouvement de rotation.

2. Dispositif selon la revendication 1, caractérisé en ce que le moteur d'entraînement est un moteur électrique (30).

3. Dispositif selon la revendication 1, caractérisé en ce que la transmission (3, 28) est une transmission mécanique.

4. Dispositif selon la revendication 1, caractérisé en ce que l'élément de levage est réalisé sous la forme d'une tige de poussée (24, 25).

5. Dispositif selon la revendication 1, caractérisé en ce que le porte-substrats est réalisé sous la forme d'un bras basculant (1) ou d'un plateau tournant (6).

6. Dispositif selon la revendication 1, caractérisé en ce que la transmission (3, 28) est réalisée sous la forme d'une transmission à cames comportant un rouleau cylindrique (32).

7. Dispositif selon la revendication 6, caractérisé en ce qu'il est prévu sur la face frontale du rouleau (32) une gorge (33, 34) fermée sur elle-même, et en ce qu'il est prévu à une extrémité de la tige de poussée (24, 25) des organes de guidage, de préférence des goujons (26, 27) qui sont guidés dans cette gorge (33, 34).

8. Dispositif selon la revendication 6, caractérisé en ce qu'il est prévu sur la surface enveloppe cylindrique du rouleau (32) une gorge périphérique (35) de préférence en forme d'hélice, et en ce qu'il est prévu sur l'axe de rotation (7) du plateau tournant (6) des organes de guidage, de préférence des goujons (36) qui sont guidés dans cette gorge (35).

9. Dispositif selon la revendication 1, caractérisé en ce qu'il est prévu à l'intérieur de la chambre un plateau tournant (6) en rotation autour d'un axe de rotation (7) fixe.

10. Dispositif selon la revendication 9, caractérisé en ce que le plateau tournant (6) est pourvu d'au moins deux évidements dans lesquels sont retenus et guidés des plateaux de substrats (22, 23) pour le levage et l'abaissement des substrats.

11. Dispositif selon la revendication 10, caractérisé en ce que les plateaux de substrats (22, 23) sont reliés chacun à une tige de poussée (24, 25).

12. Dispositif selon la revendication 11, caractérisé en ce que les tiges de poussée (24, 25) et l'axe de rotation (7) sont reliés à une transmission (28) qui est agencée au-dessous de la chambre (16).

13. Dispositif selon la revendication 5, caractérisé en ce qu'un bras basculant (1) est agencé à l'extérieur de la chambre (16) et est relié à une transmission (3).

14. Dispositif selon la revendication 13, caractérisé en ce que le bras basculant (1) coopère avec la transmission (3) de telle sorte qu'il effectue un mouvement de levage et de rotation.
